# EUROPEAN PATENT APPLICATION

(11) **EP 0 869 612 A1**
(43) Date of publication of application: **07.10.1998**
(21) Application number: 97302345.0
(22) Date of filing: 04.04.1997
(51) Int. Cl.: H03K 17/79, H03K 17/567

(54) **The pre-positioned photoelectric transducer driven insulated-gate bipolar transistor**

(71) Applicant: Yang, Tai-Her, Si-Hu Town, Dzan-Hwa (TW)
(72) Inventor: Yang, Tai-Her, Si-Hu Town, Dzan-Hwa (TW)
(74) Representative: Wright, Howard Hugh Burnby

(57) **Abstract**

The pre-positioned photoelectric transducer driven insulated-gate bipolar transistor(IGBT) is disclosed by the photoelectric illumination components matching with the low voltage electric power converting into light energy, such as LED or electric bulbs, etc. and their coupled photoelectric transducer components such as crystal series or non-crystal series cells, etc. to generate high voltage small current signals to the gate electrode and emitter electrode of the insulated-gate bipolar transistor (IGBT), whereby the insulated-gate bipolar transistor(IGBT) is driven to ensures that the insulated-gate bipolar transistor driven from a low voltage signal source can work normally.

## Description

### SUMMARY OF THE INVENTION

The pre-positioned photoelectric transducer driven insulated-gate bipolar transistor(IGBT) is disclosed by the photoelectric illumination components matching with the low voltage electric power converting into light energy, such as LED or electric bulbs, etc. and their coupled photoelectric transducer components such as crystal series or non-crystal series cells, etc. to generate high voltage small current signals to the gate electrode and emitter electrode of the insulated-gate bipolar transistor (IGBT), whereby the insulated-gate bipolar transistor(IGBT) is driven to ensures that the insulated-gate bipolar transistor driven from a low voltage signal source can work normally.

### BRIEF DESCRIPTION OF THE DRAWINGS

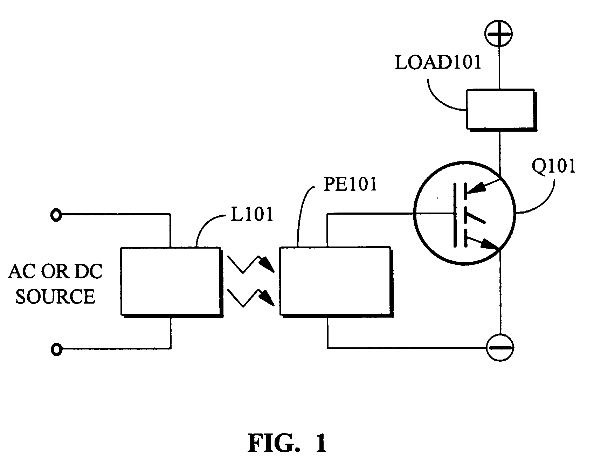

Figure 1 is a basic circuit block diagram of the invention

### DETAILED DESCRIPTION OF THE INVENTION

As it is a well known fact that the insulated-gate bipolar transistor(IGBT) is a latest developed solid state power switching component which has a wide range applications due to its large switching capacity and convenience in usage; nonetheless, since the control end of the insulated-gate bipolar transistor (IGBT) is at high impedance status, the matching driving signal shall be low current but at a higher voltage; whereby as shown in the example of the attachment, usually the voltage shall be above 12V in order to ensure normal operation, thereof if the voltage of the driving signal between the gate and emitter is too low then the impedance between the collector and emitter becomes too large to cause the switch heat loss suddenly increased and burnout, hereby to restrict its low voltage applications; thereof the one shown in the attachment is a work characteristic diagram of a conventional insulated-gate bipolar transistor(IGBT), whereof the driving signal of the said insulated-gate bipolar transistor(IGBT) shown in the attachment shall not be lower than 12V.

The pre-positioned photoelectric transducer driven insulated-gate bipolar transistor(IGBT) is disclosed by the photoelectric illumination components matching with the low voltage electric power converting into light energy, such as LED or electric bulbs, etc. and their coupled photoelectric transducer components such as crystal series or non-crystal series cells, etc. to generate high voltage small current signals to the gate electrode and emitter electrode of the insulated-gate bipolar transistor (IGBT), whereby the insulated-gate bipolar transistor(IGBT) is driven to ensures that the insulated-gate bipolar transistor driven from a low voltage signal source can work normally.

Figure 1 is a basic circuit block diagram of the pre-positioned photoelectric transducer driven insulated-gate bipolar transistor, wherein it is mainly comprised of the following:
- The insulated-gate bipolar transistors set Q101: It is constituted by a single uni-polar unit or two units in contrary polarities or other various bridge module structures, whereby the photoelectric transducers are provided to matched with the numbers of the insulated-gate bipolar transistors (IGBT);
- A photoelectric transducer component PE101: It is constituted by a crystal series or a non-crystal series photoelectric cell for converting light energy into electric power, or other types of components which convert light energy into electric power, wherein it is for supplying the driving voltage higher than the lowest required by the insulated-gate bipolar transistor in normal light receiving status;
- The illuminating component L101 matching with the low voltage electric power converting into light energy: It is constituted by the components matching with the low voltage electric power converting into light energy, such as the light emitting diode LED or electric bulbs,etc.; hereof the low voltage is defined to be the voltage lower than the lowest required driving voltage of the insulated-gate bipolar transistor(IGBT), whereof its matching status with the photoelectric transducer component PE101 is one to one or one light emitting diode LED is employed to drive two or more than two photoelectric transducer components PE101 simultaneously;
- A load 101: It includes the various loads such as the mechanical energy generated by electric power, light, heat or electrochemical effect or other resistive, capacitive or inductive loads.

By combinations of the aforesaid components, the photoelectric transducer component which can generate high voltage small current at normal light receiving status is parallel installed between the gate electrode and emitter electrode of the insulated-gate bipolar transistor as well as the low voltage electric power converting to light energy illuminating components such as light emitting diode LED, electric bulbs, etc coupled with the photoelectric transducer component is installed, thereby when the low voltage electric power converting into light energy illuminating components are illuminated, the photoelectric transducer component PE101 is excited to generate a corresponding high voltage small current driving signal to drive the insulated-gate bipolar transducer (IGBT).

The aforesaid low voltage electric power converting to light energy illuminating component L101 and the photoelectric transducer component PE101 can be embodied in a mutually coupled sealing structure status as structure required.

The aforesaid low voltage electric power converting into light energy illuminating component L101 and the photoelectric transducer component PE101 can be separately installed or embodied in an integral module package as structure required.

The aforesaid low voltage electric power source can be DC or AC current to drive the electric bulb, or DC power can be used to drive the light emitting, or other power can be used to excite the illuminating components.

The aforesaid low voltage power driven electric bulb or light emitting diode or other illuminating components driven by low voltage electric power can be substituted by a natural light source.

As summarized from the above descriptions, the pre-positioned photoelectric transducer driven insulated-gate bipolar transistor(IGBT) is by the low voltage electric power converting to light energy illuminating component to couple with the photoelectric transducer component to generate high voltage small current at normal light receiving status, thereby to further constitute the pre-positioned driving circuit for the insulated-gate bipolar transistor and is characterized in that the insulated-gate bipolar transistor can also be well operated at low voltage driving signal source input, hereto the applicant have surveyed through the literature have found no related prior arts, therefore your lawful approval on the application is expected and appreciated.

## Claims

1. A pre-positioned photoelectric transducer driven insulated-gate bipolar transistor(IGBT) is disclosed by the photoelectric illumination components matching with the low voltage electric power converting into light energy, such as LED or electric bulbs, etc. and their coupled photoelectric transducer components such as crystal series or non-crystal series cells, etc. to generate high voltage small current signals to the gate electrode and emitter electrode of the insulated-gate bipolar transistor (IGBT), whereby the insulated-gate bipolar transistor(IGBT) is driven to ensures that the insulated-gate bipolar transistor driven from a low voltage signal source can work normally.

2. A pre-positioned photoelectric transducer driven insulated-gate bipolar transistor(IGBT) as in claim 1, wherein its basic circuit is mainly comprised of the following:
• The insulated-gate bipolar transistors set Q101: It is constituted by a single uni-polar unit or two units in contrary polarities or other various bridge module structures, whereby the photoelectric transducers are provided to matched with the numbers of the insulated-gate bipolar transistors (IGBT);
• A photoelectric transducer component PE101: It is constituted by a crystal series or a non-crystal series photoelectric cell for converting light energy into electric power, or other types of components which convert light energy into electric power, wherein it is for supplying the driving voltage higher than the lowest required by the insulated-gate bipolar transistor in normal light receiving status;
• The illuminating component L101 matching with the low voltage electric power converting into light energy: It is constituted by the components matching with the low voltage electric power converting into light energy, such as the light emitting diode LED or electric bulbs,etc.; hereof the low voltage is defined to be the voltage lower than the lowest required driving voltage of the insulated-gate bipolar transistor(IGBT), whereof its matching status with the photoelectric transducer component PE101 is one to one or one light emitting diode LED is employed to drive two or more than two photoelectric transducer components PE101 simultaneously;
• A load 101: It includes the various loads such as the mechanical energy generated by electric power, light, heat or electrochemical effect or other resistive, capacitive or inductive loads.

3. A pre-positioned photoelectric transducer driven insulated-gate bipolar transistor(IGBT) as in claim 1, wherein its low voltage electric power converting to light energy illuminating component L101 and the photoelectric transducer component PE101 can be embodied in a mutually coupled sealing structure status as structure required.

4. A pre-positioned photoelectric transducer driven insulated-gate bipolar transistor(IGBT) as in claim 1, wherein its low voltage electric power converting into light energy illuminating component L101 and the photoelectric transducer component PE101 can be separately installed or embodied in an integral module package as structure required.

5. A pre-positioned photoelectric transducer driven insulated-gate bipolar transistor(IGBT) as in claim 1, wherein its low voltage electric power source can be DC or AC current to drive the electric bulb, or DC power can be used to drive the light emitting, or other power can be used to excite the illuminating components.

6. A pre-positioned photoelectric transducer driven insulated-gate bipolar transistor(IGBT) as in claim 1, wherein its low voltage power driven electric bulb or light emitting diode or other illuminating components driven by low voltage electric power can be substituted by a natural light source.

7. A photoelectric transducer and transistor circuit comprising:
a photoelectric transducer for detecting light and serving to generate a signal voltage on the basis of the detected light; and
an insulated-gate bipolar transistor having a gate which receives the signal voltage from the transducer, the transistor being operable on the basis of the signal voltage,
wherein the transducer and transistor are voltage matched so that variations in detected light cause variations in the signal voltage which cause switching of the transistor.

8. A circuit according to claim 7 wherein the photoelectric transducer is connected directly to the gate of the transistor.

9. A circuit according to claims 7 or 8, further comprising a source of light.

10. A circuit according to any one of claims 7, 8 or 9, wherein the transducer is positioned so as to detect the light.
